# EUROPEAN PATENT SPECIFICATION

(11) **EP 4 422 365 B1**
(45) Date of publication and mention of the grant of the patent: **25.02.2026**
(21) Application number: 22906308.6
(22) Date of filing: 06.12.2022
(51) Int. Cl.: H05K 5/02, H04M 1/02, H05K 5/00, H05K 5/06

(54) **ELECTRONIC DEVICE**
ELEKTRONISCHE VORRICHTUNG
DISPOSITIF ÉLECTRONIQUE

(30) Priority: 16.12.2021 CN 202111544364
(43) Date of publication of application: 28.08.2024
(73) Proprietor: Huawei Technologies Co., Ltd., Shenzhen, Guangdong 518129 (CN)
(72) Inventor: LIU, Zhaoqiang, Shenzhen, Guangdong 518129 (CN); BAO, Jinghan, Shenzhen, Guangdong 518129 (CN); ZHOU, Hao, Shenzhen, Guangdong 518129 (CN); MAO, Xingyu, Shenzhen, Guangdong 518129 (CN)
(74) Representative: Isarpatent
(86) International application number: PCT/CN2022/136724
(87) International publication number: WO 2023/109558

(56) References cited:
- EP-A2- 2 086 301
- CN-A- 101 686 622
- CN-A- 102 123 561
- CN-A- 109 451 685
- CN-A- 111 655 009
- DE-A1- 10 314 541
- US-A1- 2014 016 996

## Description

Priority is claimed to Chinese Patent Application No. 202111544364.2, filed with the China National Intellectual Property Administration on December 16, 2021 and entitled "ELECTRONIC DEVICE".

### TECHNICAL FIELD

This disclosure generally relates to the field of electronic device technologies, and the invention in particular relates to a portable electronic device.

### BACKGROUND

Currently, a handle needs to be reserved on an electronic device for disassembly in a product line. Because the handle may damage an appearance of the electronic device and affect appearance exquisiteness of a product, designing an electronic device that is easy to disassemble and that does not affect an appearance of the product becomes an important development trend.

US 2014/016 996 A1 describes an opening mechanism of housings for electronic devices and that a removing tool is used for detaching a second housing from a first housing. Ejecting pins can be slid toward the inside of a receiving cavity in which an electronic device is positioned. The ejecting pins are driven to press against removable portions which are part of the side wall of the second housing. The removable portion break at dedicated positions and each removable portion falls inside of the second housing and a corresponding latching groove is exposed from the second housing. When the ejecting pins are further pushed, then the respective pin will press against the hooks, which then will glide from the latching grooves. Once the housing of the device has been opened, the second housing must be replaced as the removable portion are broken.

### SUMMARY

The object of the present invention is to provide an electronic device which can simplify a disassembly design of an electronic device without affecting aesthetics of the electronic device and provides a reusable snap-mechanism. This object is solved by the attached independent claim and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

The invention provides the following electronic device 10. The electronic device 10 includes a first housing 100 and a second housing 200. The first housing 100 is provided with a first clamping member 111 and a stopper 121. The second housing 200 is provided with a first cavity 220, a sliding member 600, and a second clamping member 231. The first cavity 220 is provided with a first hole 210 and a sliding block 600. The first cavity 220 communicates with the outside through the first hole 210. The first hole 210 is at least partially opposite to the sliding block 600, the first clamping member 111 and the second clamping member 231 may be clamped and connected, and the first housing 100 and the second housing 200 may be clamped and connected by using the first clamping member 111 and the second clamping member 231. When the first clamping member 111 and the second clamping member 231 are clamped, the first housing 100 and the second housing 200 are clamped, and projections of the sliding member 600 and the stopper 121 at least partially overlap in a first direction P1, where the first direction P1 is a direction of the first hole 210 towards the sliding member 600.

When an acting force acts on the sliding member 600 through the first hole 210, the sliding member 600 may move along the first direction P1, the stopper 121 may generate displacement relative to the sliding member 600 in a second direction P2, and the stopper 121 generates displacement in the second direction P2, so that the first clamping member 111 and the second clamping member 231 can change from clamping to separation, and the first housing 100 and the second housing 200 change from clamping to separation, so that the electronic device 10 is opened. The second direction P2 is a direction in which the second housing 200 extends to the first housing 100. Because the sliding member 600 may open the electronic device 10 by moving along the first direction P1, no buckle needs to be disposed, thereby ensuring integrity of an appearance of the electronic device 10 and improving product competitiveness.

According to the invention, the stopper 121 has a first surface 1211, the sliding member 600 has a second surface 6001, and at least one of the first surface 1211 or the second surface 6001 is a bevel or an arc surface. Because projections of the stopper 121 and the sliding member 600 in the first direction P1 at least partially overlap, projections of the first surface 1211 and the second surface 6001 in the first direction P1 at least partially overlap.

In this embodiment of this application, when the first housing 100 and the second housing 200 are clamped and connected by using the first clamping member 111 and the second clamping member 231, the sliding member 600 may at least partially abut against the stopper 121. When an acting force acts on the sliding member 600 through the first hole 210, the sliding member 600 may move along the first direction P1 to push the stopper 121 to generate displacement in the second direction P2, so that the electronic device 10 is opened. Because the sliding member 600 at least partially abuts against the stopper 121, when the sliding member 600 moves along the first direction P1 to push the stopper 121 to open the electronic device 10, a sliding displacement of the sliding member 600 is shortened, a speed of opening the electronic device 10 is improved, and product competitiveness is improved.

In this embodiment of this application, a bottom surface and a side wall may be disposed in the first cavity 220. A second protrusion 224 may be disposed on the bottom surface of the first cavity 220, a side arm 225 may be disposed on the side wall of the first cavity 220, and first sliding space 226 may be formed between the second protrusion 224 and the side arm 225. A first sliding part 6002 may be disposed on the sliding member 600, and the first sliding part 6002 is disposed in the first sliding space 226. When an acting force acts on the sliding member 600 through the first hole 210, the sliding member 600 may move along the first direction P1, the first sliding part 6002 may move in the first sliding space 226 along the first direction P1, and the stopper 121 generates displacement relative to the sliding member 600 in the second direction P2, so that the electronic device 10 is opened. The first sliding space 226 is formed by using a structure of the first cavity 220, and at least a part of the structure of the sliding member 600 slides to cooperate with the first sliding space 226. This simplifies a structural design and improves product competitiveness.

In this embodiment of this application, the bottom surface and an elastic member 500 may be disposed in the first cavity 220. A first protrusion 223 may be disposed on the bottom surface of the first cavity 220, a second hole 501 may be disposed on the elastic member 500, and the elastic member 500 and the first protrusion 223 may cooperate with each other through the second hole 501, to prevent the elastic member 500 from falling off.

In this embodiment of this application, the elastic member 500 may be provided with a first step part 503, and second sliding space 227 may be formed between the first step part 503 and the bottom surface of the first cavity 220. A second sliding part 6003 and a third sliding part 6004 may be disposed on the sliding member 600. The second sliding part 6003 is disposed in the second sliding space 227. The third sliding part 6004 is in contact with the bottom surface of the first cavity 220. When an acting force acts on the sliding member 600 through the first hole 210, the sliding member 600 may move along the first direction P1, and the second sliding part 6003 may move in the second sliding space 227 along the first direction P1. The third sliding part 6004 may move on the bottom surface of the first cavity 220 along the first direction P1, and the stopper 121 generates displacement relative to the sliding member 600 in the second direction P2, so that the electronic device 10 is opened, thereby improving product competitiveness. The second sliding space 227 is formed by using the first cavity 220 and at least a part of the structure of the elastic member 500, and at least a part of the structure of the sliding member 600 slides to cooperate with the second sliding space 227. This simplifies a structural design and improves product competitiveness.

In this embodiment of this application, a sliding slot may be disposed on the bottom surface of the first cavity 220, the sliding slot extends along the first direction P1, and the third sliding part 6004 is disposed on the sliding slot. When an acting force acts on the sliding member 600 through the first hole 210, the sliding member 600 may move along the first direction P1, and the third sliding part 6004 may move on the sliding slot of the bottom surface of the first cavity 220 along the first direction P1. The stopper 121 generates displacement relative to the sliding member 600 in the second direction P2, so that the electronic device 10 is opened. By cooperating with the third sliding part 6004, the sliding slot provides a sliding support function for the third sliding part 6004, and this reduces uncertainty of a sliding route, and improves structural reliability and product competitiveness.

In this embodiment of this application, the elastic member 500 may be in interference fit with the first protrusion 223. When the first housing 100 and the second housing 200 change from clamping to separation, the elastic member 500 and the first protrusion 223 are prevented from falling off.

In this embodiment of this application, the elastic member 500 may be in interference fit with the first cavity 220. When the first housing 100 and the second housing 200 change from clamping to separation, the elastic member 500 is prevented from falling off from the first cavity 220.

In this embodiment of this application, the sliding member 600 may be provided with a first connecting piece 6007. The first connecting piece 6007 may be provided with a neck 6005 of the first connecting piece and a head 6006 of the first connecting piece. The first hole 210 is at least partially opposite to the sliding block 600, and the first hole 210 is at least partially opposite to the neck 6005 of the first connecting piece. When an acting force acts on the neck 6005 of the first connecting piece through the first hole 210, the neck 6005 of the first connecting piece moves along the first direction P1, the sliding member 600 moves along the first direction P1, and the stopper 121 generates displacement relative to the sliding member 600 in the second direction P2, so that the electronic device 10 is opened. The neck 6005 of the first connecting piece and the head 6006 of the first connecting piece are disposed, and an acting force acts on the neck 6005 of the first connecting piece, so that the sliding member 600 performs sliding, alternatively, a rope may be disposed on the neck 6005 of the first connecting piece to implement a function of hanging a decoration part. By reusing a function of the neck 6005 of the first connecting piece, not only a cover may be opened by using the sliding member 600, but also a function of hanging a rope may be implemented by using the sliding member 600, and this improves product competitiveness.

In this embodiment of this application, a length L7 of the head 6006 of the first connecting piece may be greater than a length L6 of the neck 6005 of the first connecting piece, or a width W3 of the head 6006 of the first connecting piece may be greater than a width W2 of the neck 6005 of the first connecting piece, so that when a rope is disposed on the neck 6005 of the first connecting piece, the rope can be prevented from falling off from the neck 6005 of the first connecting piece by using a size relationship.

In this embodiment of this application, the stopper 121 and the first housing 100 may be integrally formed, so that the stopper 121 can be prevented from falling off from the first housing 100. This simplifies a design of a structural part.

In this embodiment of this application, a material of the elastic member 500 may be at least one of plastic, metal, or rubber.

In this embodiment of this application, the first housing 100 may be provided with a sealing kit 112, and the second housing 200 may be provided with a second cavity 230. When the first housing 100 and the second housing 200 are clamped and connected by using the first clamping member 111 and the second clamping member 231, the first cavity 220 may be separated with the second cavity 230 by using the sealing kit 112, and the second cavity 230 may be sealed by using the sealing kit 112 to prevent water, stains, and the like from entering the second cavity 230, to erode a device in the second cavity 230.

In this embodiment of this application, a battery 300 and a circuit board 400 may be disposed in the second cavity 230.

In not claimed embodiments of this disclosure, the electronic device 10 may be an electronic label device, an electronic tracking device, an electronic positioning device, a mobile phone, a watch, a tablet computer, a laptop computer, or an ultra-mobile personal computer (ultra-mobile personal computer, UMPC), a handheld computer, a touch television, a walkie-talkie, a netbook, a POS terminal, a wearable device, a virtual reality device and other electronic products.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### BRIEF DESCRIPTION OF DRAWINGS

FIG. 1 is a schematic diagram of an electronic device according to an embodiment of this application;
FIG. 2 is an exploded view of the electronic device shown in FIG. 1;
FIG. 3 is a schematic diagram of a structure of the electronic device shown in FIG. 1 in a fully open state;
FIG. 4 is a schematic diagram of a structure of the first housing shown in FIG. 3;
FIG. 5 is a sectional view of the first housing shown in FIG. 4 along B-B;
FIG. 6 is an exploded view of the first cavity shown in FIG. 3;
FIG. 7 is a sectional view of the first cavity shown in FIG. 6 along C-C;
FIG. 8 is a schematic diagram of a structure of an elastic member shown in FIG. 6 from a first perspective;
FIG. 9 is a schematic diagram of a structure of an elastic member shown in FIG. 6 from a second perspective;
FIG. 10 is a sectional view of an elastic member after being placed in a first cavity along C-C;
FIG. 11 is a schematic diagram of a structure of a sliding member shown in FIG. 6 from a first perspective;
FIG. 12 is a schematic diagram of a structure of a sliding member shown in FIG. 6 from a second perspective;
FIG. 13 is a sectional view of the first cavity shown in FIG. 3 along A-A;
FIG. 14 is a schematic diagram of structures of an electronic device and an ejector pin according to an embodiment of this application;
FIG. 15 is a sectional view of the electronic device and the ejector pin shown in FIG. 14 along D-D;
FIG. 16 is a schematic diagram of a structure of the ejector pin shown in FIG. 14 in combination with an electronic device along a first direction;
FIG. 17 is a sectional view of the schematic structural diagram shown in FIG. 16 along E-E;
FIG. 18 is a schematic structural diagram in which an ejector pin opens the electronic device shown in FIG. 1 along a first direction;
FIG. 19 is a sectional view of the schematic structural diagram shown in FIG. 18 along F-F; and
FIG. 20 is a schematic diagram of a structure of the electronic device shown in FIG. 1 in a half-open state.

### DESCRIPTION OF EMBODIMENTS

Embodiments of this application provide an electronic device.

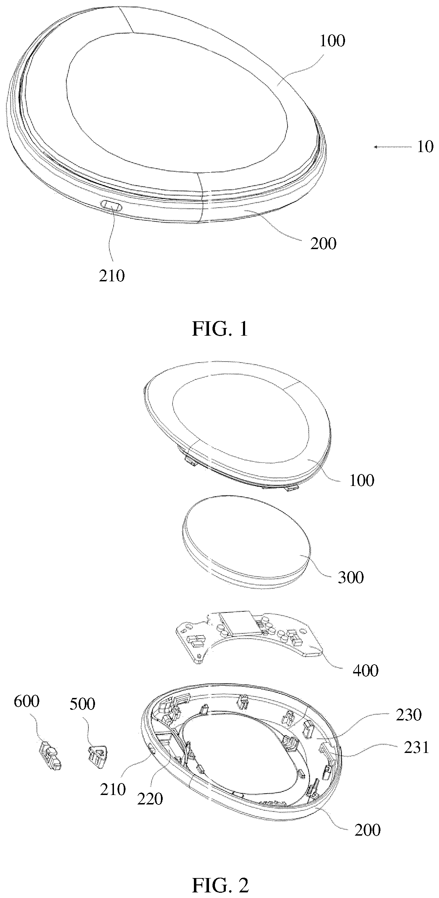

FIG. 1 is a schematic diagram of an electronic device according to an embodiment of this application.

The electronic device in this embodiment of this application may be an electronic label device, an electronic tracking device, an electronic positioning device, a mobile phone, a watch, a tablet computer, a laptop computer, an ultra-mobile personal computer (ultra-mobile personal computer, UMPC), a handheld computer, a touch television, a walkie-talkie, a netbook, a POS terminal, a wearable device, a virtual reality device, or the like.

An electronic device 10 includes a first housing 100 and a second housing 200. The first housing 100 is combined with the second housing 200, and the second housing 200 is provided with a first hole 210.

FIG. 2 is an exploded view of the electronic device shown in FIG. 1. The first housing 100, the second housing 200, a battery 300, a circuit board assembly 400, an elastic member 500, and a sliding member 600 are included. The second housing 200 is provided with a first cavity 220 and a second cavity 230, the first cavity 220 is provided with the first hole 210, and the second cavity 230 has a second clamping member 231.

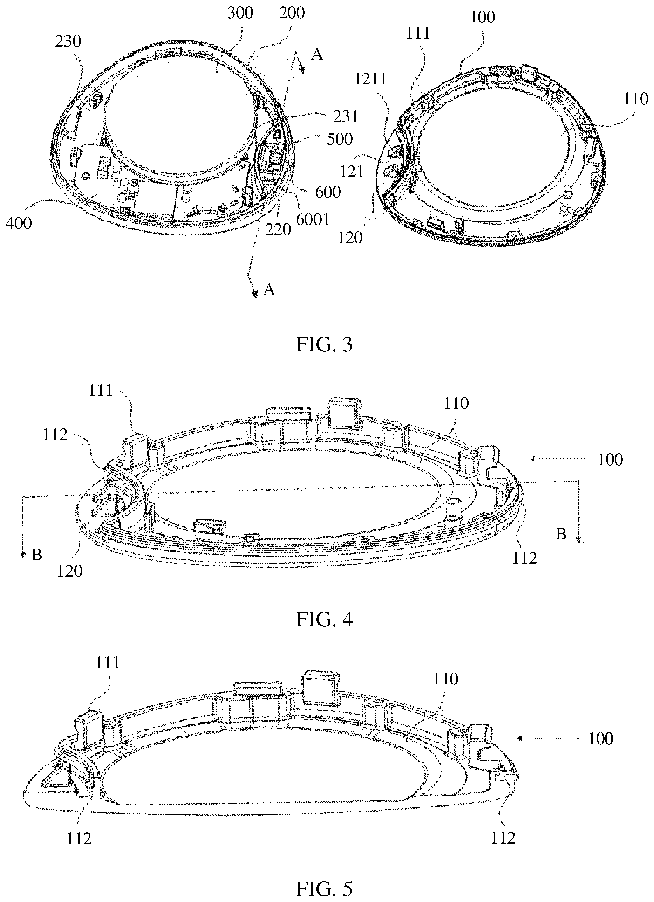

FIG. 3 is a schematic diagram of a structure of the electronic device shown in FIG. 1 in a fully open state. The first housing 100 is provided with first accommodating space 110 and second accommodating space 120. A first clamping member 111 is disposed in the first accommodating space 110, a stopper 121 is disposed in the second accommodating space 120, and the stopper 121 has a first surface 1211. The second housing 200 is provided with a first cavity 220 and a second cavity 230. An elastic member 500 and a sliding member 600 are disposed inside the first cavity 220, and the sliding member 600 has a second surface 6001. A battery 300, a circuit board assembly 400, and a second clamping member 231 are disposed inside the second cavity 230. The first clamping member 111 may be connected to the second clamping member 231 through buckling, and the first housing 100 and the second housing 200 are connected to each other by using the first clamping member 111 and the second clamping member 231, so that the first housing 100 and the second housing 200 of the electronic device 10 can be firmly combined.

In this embodiment of this application, more than one first clamping member 111 may be disposed in the first housing 100, and more than one second clamping member 231 may be disposed inside the second cavity 230. A plurality of first clamping members 111 and a plurality of second clamping members 231 may be connected in a pairing manner through buckling. The first housing 100 and the second housing 200 may be connected by using the plurality of first clamping members 111 and the plurality of second clamping members 231, so that the first housing 100 and the second housing 200 of the electronic device 10 are firmly combined.

FIG. 4 is a schematic diagram of a structure of the first housing shown in FIG. 3. FIG. 5 is a sectional view of the first housing shown in FIG. 4 along B-B. The first housing 100 is further provided with a sealing kit 112, the sealing kit 112 is placed outside the first accommodating space 110, and the first accommodating space 110 and the second accommodating space 120 are separated by using the sealing kit 112. When the first housing 100 and the second housing 200 are combined, the first cavity 220 and the second cavity 230 may also be separated by using the sealing kit 112. The first housing 100 and the second housing 200 may form a sealed cavity by using the sealing kit 112. Because the first cavity 220 communicates with the outside through the first hole 210, substances such as water and air may enter the first cavity 220 through the first hole 210, and the second cavity 230 may be isolated from the first cavity 220 by using the sealing kit 112, so that the battery 300, the circuit board assembly 400, and the like inside the second cavity 230 are prevented from being damaged, thereby ensuring product sealing performance.

In this embodiment of this application, a material of the sealing kit 112 may be rubber.

In this embodiment of this application, the sealing kit 112 may be elastic. When the sealing kit 112 is placed outside the first accommodating space 110, because the sealing kit 112 is squeezed by an outer wall of the first accommodating space 110, a rebound function of the sealing kit 112 may enable the sealing kit 112 to be closely combined with the first housing 100, to prevent the sealing kit 112 from falling off from the first housing 100.

In this embodiment of this application, the outer wall of the first accommodating space 110 may alternatively be elastic. When the sealing kit 112 is placed outside the first accommodating space 110, because the outer wall of the first accommodating space 110 is squeezed by the sealing kit 112, a rebound function of the outer wall of the first accommodating space 110 may enable the sealing kit 112 to be closely combined with the first housing 100, to prevent the sealing kit 112 from falling off from the first housing 100.

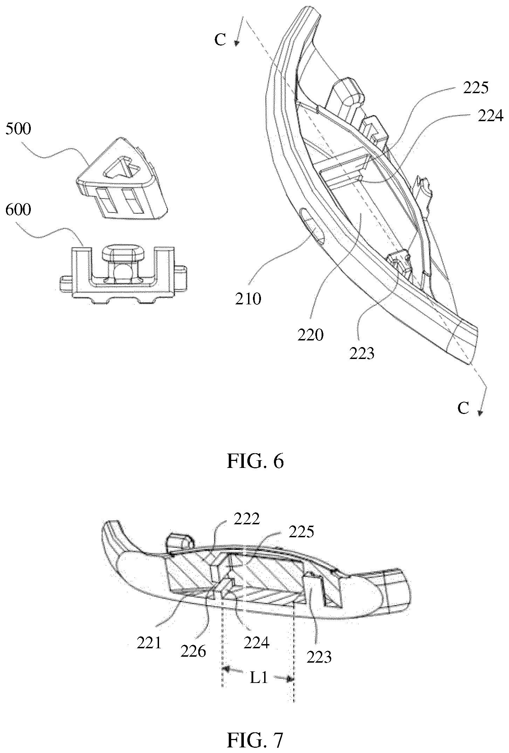

FIG. 6 is an exploded view of the first cavity shown in FIG. 3, including the first cavity 220, the elastic member 500, and the sliding member 600. The first cavity 220 is provided with a first protrusion 223, a second protrusion 224, and a side arm 225. FIG. 7 is a sectional view of the first cavity shown in FIG. 6 along C-C. The first cavity 220 has a length L1, and the first cavity 220 has a bottom surface and a side wall. The bottom surface of the first cavity 220 and/or the side wall of the first cavity 220 may be smooth, and the bottom surface of the first cavity 220 and/or the side wall of the first cavity 220 may alternatively be uneven. The first protrusion 223 and the second protrusion 224 are disposed on the bottom surface of the first cavity 220, a side arm 225 is disposed on the side wall of the first cavity 220, and first sliding space 226 is formed between the side arm 225 and the second protrusion 224.

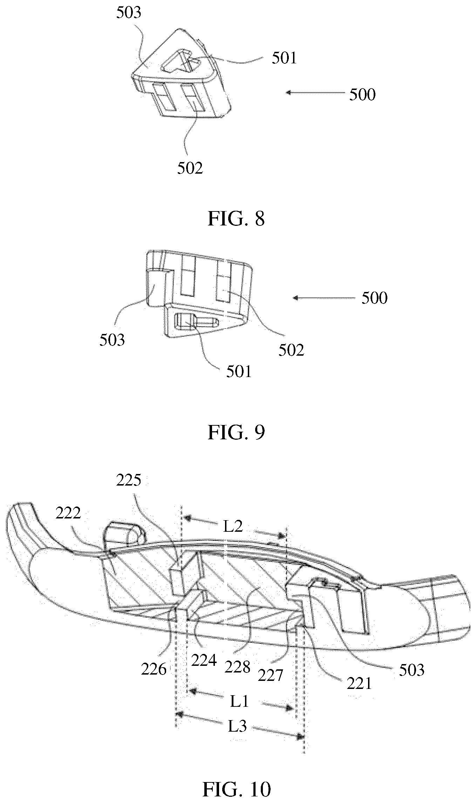

FIG. 8 is a schematic diagram of a structure of the elastic member shown in FIG. 6 from a first perspective. FIG. 9 is a schematic diagram of a structure of the elastic member shown in FIG. 6 from a second perspective. The elastic member 500 is provided with a second hole 501, an elastic part 502, and a first step part 503. FIG. 10 is a sectional view of an elastic member after being placed in a first cavity 220 shown in FIG. 6 along C-C. After the elastic member 500 is placed in the first cavity 220, the first cavity 220 further has a length L2 and a length L3, second sliding space 227 is formed between the first step part 503 and the bottom surface of the first cavity 220, and third sliding space 228 is formed between the first sliding space 226, the second sliding space 227, the side arm 225, the second protrusion 224, the side wall of the first cavity 220, the first step part 503, and the bottom surface of the first cavity 220.

In this embodiment of this application, the elastic member 500 and the first protrusion 223 may be combined through a second hole 501, and the first protrusion 223 abuts against an inner wall of the elastic member 500. Because the inner wall of the elastic member 500 is squeezed by the first protrusion 223, a rebound function of the elastic member 500 may enable the first protrusion 223 to be closely combined with the elastic member 500, to prevent the elastic member 500 from falling off.

In this embodiment of this application, the first protrusion 223 may alternatively be elastic, and the elastic member 500 and the first protrusion 223 are combined through the second hole 501. Because the first protrusion 223 is squeezed by the inner wall of the elastic member 500, a rebound function of the first protrusion 223 may enable the first protrusion 223 and the elastic member 500 to be tightly combined, to prevent the elastic member 500 from falling off.

In this embodiment of this application, the elastic member 500 may have more than one second hole 501, and the first cavity 220 may have more than one first protrusion 223. The elastic member 500 and a plurality of first protrusions 223 are combined through a plurality of second holes 501, and the plurality of first protrusions 223 abut against the inner wall of the elastic member 500. Because the inner wall of the elastic member 500 is squeezed by the plurality of first protrusions 223, the rebound function of the elastic member 500 may enable the plurality of the first protrusions 223 to be tightly combined with the elastic member 500, to prevent the elastic member 500 from falling off.

In this embodiment of this application, the first protrusion 223 may alternatively be elastic, the elastic member 500 may have more than one second hole 501, the first cavity 220 may have more than one first protrusion 223, the elastic member 500 is combined with the plurality of first protrusions 223 through the plurality of second holes 501, and the plurality of first protrusions 223 abut against the inner wall of the elastic member 500. Because the plurality of first protrusions 223 are squeezed by the inner wall of the elastic member 500, rebound functions of the plurality of first protrusions 223 may enable the plurality of first protrusions 223 to be tightly combined with the elastic member 500, to prevent the elastic member 500 from falling off.

In this embodiment of this application, the second hole 501 may be a through hole, a height of the first protrusion 223 may be consistent with a length of the second hole 501, and the elastic member 500 is combined with the first protrusion 223 through the second hole 501. Because a contact area between the inner wall of the elastic member 500 and the first protrusion 223 is large, the first protrusion 223 and the elastic member 500 can be tightly combined, to prevent the elastic member 500 from falling off.

In this embodiment of this application, an elastic part 502 may abut against the inner wall of the first cavity 220, and a rebound function of the elastic part 502 may enable the elastic member 500 to be tightly combined with the first cavity 220, to prevent the elastic member 500 from falling off.

In this embodiment of this application, more than one elastic part 502 may be disposed on the elastic member 500, and a plurality of elastic parts 502 abut against the inner wall of the first cavity 220. The elastic member 500 and the first cavity 220 can be tightly combined through rebound functions of the plurality of elastic parts 502, to prevent the elastic member 500 from falling off.

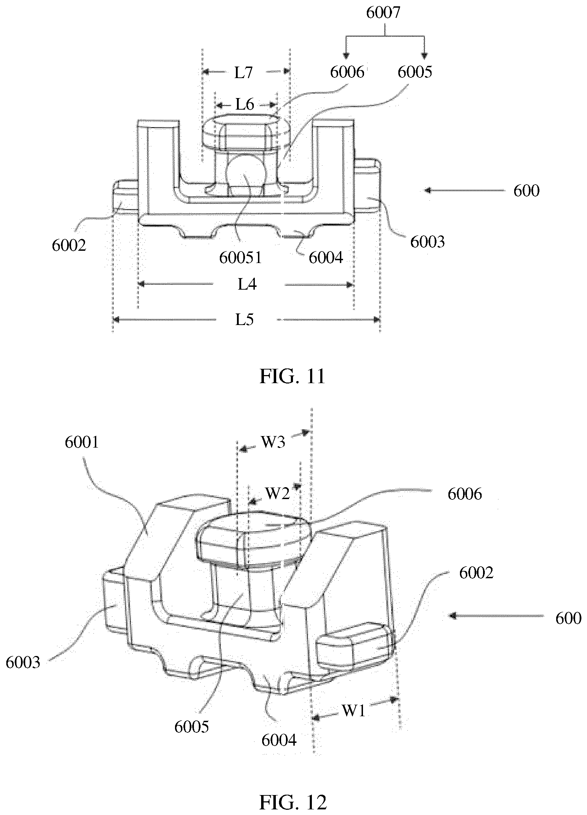

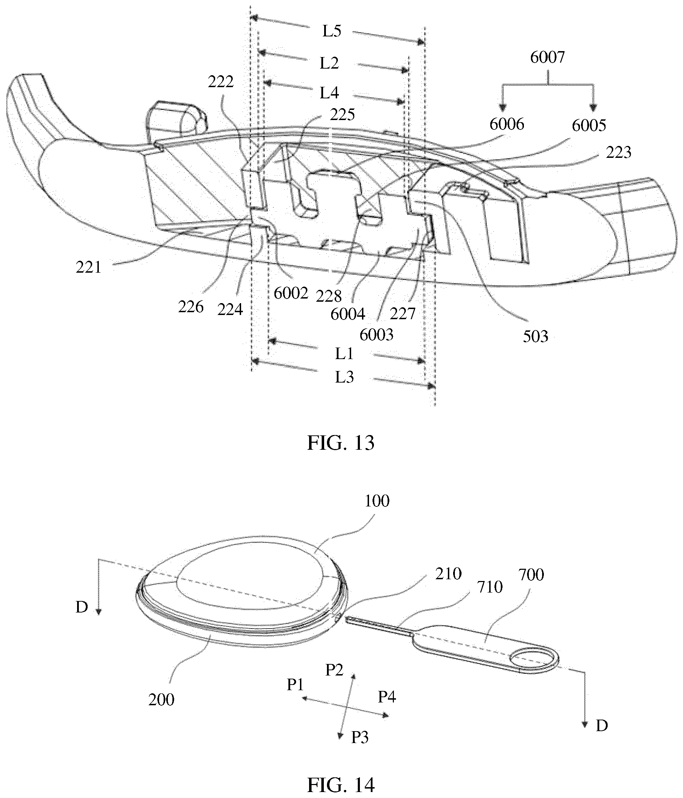

FIG. 11 is a schematic diagram of a structure of the sliding member shown in FIG. 6 from a first perspective, including a first sliding part 6002, a second sliding part 6003, a third sliding part 6004, and a first connecting piece 6007. The sliding member 600 has a length L4 and a length L5, the first connecting piece 6007 is provided with a neck 6005 of the first connecting piece and a head 6006 of the first connecting piece, the neck 6005 of the first connecting piece has a length L6, the head 6006 of the first connecting piece has a length L7, and the neck 6005 of the first connecting piece is provided with a concave part 60051. FIG. 12 is a schematic diagram of a structure of the sliding member shown in FIG. 4 from a second perspective. The sliding member 600 further has a second surface 6001. The sliding member 600 has a width W1, a neck 6005 of the first connecting piece has a width W2, and a head 6006 of the first connecting piece has a width W3. FIG. 13 is a sectional view of the first cavity shown in FIG. 3 along A-A. The sliding member 600 is placed on a bottom surface of the first cavity 220 and third sliding space 228, a second sliding part 6003 is placed in second sliding space 227, a first sliding part 6002 is placed in first sliding space 226, and a third sliding part 600 is placed on the bottom surface of the first cavity 220. The second sliding part 6003 may slide in the second sliding space 227, the first sliding part 6002 may slide in the first sliding space 226, the third sliding part 6004 may slide on the bottom surface of the first cavity 220, and the sliding member 600 may slide in the third sliding space 228.

In this embodiment of this application, the second sliding space 227 is formed between a first step part 503 of the elastic member 500 and the bottom surface of the first cavity 220, and the second sliding part 6003 of the sliding member 600 is placed in the second sliding space 227. Because the elastic member 500 may be tightly combined with a first protrusion 223, the elastic member 500 may alternatively be tightly combined with the first cavity 220 by using an elastic part 503, to prevent the sliding member 600 from falling off from the first cavity 220.

In this embodiment of this application, a length L1 of the first cavity 220 is not less than a length L4 of the sliding member 600, a length L2 of the first cavity 220 is not less than the length L4 of the sliding member 600, the length L1 of the first cavity 220 is not greater than a length L5 of the sliding member 600, and the length L2 of the first cavity 220 is not greater than the length L5 of the sliding member 600. This can prevent the sliding member 600 from falling off from the third sliding space 228.

In this embodiment of this application, a size of the first sliding part 6002 and a size of the second sliding part 6003 may be different, or an appearance of the first sliding part 6002 and an appearance of the second sliding part 6003 may be different, so that misoperation of a user when the user places the sliding member 600 in the first cavity 220 can be prevented, and a mistake proofing function is provided.

In this embodiment of this application, a neck 6005 of a first connecting piece may hang a rope, a first hole 210 may have a function of hanging a rope hole, one end of the rope is hung on the neck 6005 of the first connecting piece, and the other end of the rope extends out through the first hole 210. A length L7 of a head 6006 of the first connecting piece is greater than a length L6 of the neck 6005 of the first connecting piece, so that the rope can be prevented from falling off from the neck 6005 of the first connecting piece. Because the function of hanging the rope is implemented by using the neck 6005 of the first connecting piece, product competitiveness is improved.

In a possible implementation, the neck 6005 of the first connecting piece may hang a rope, the first hole 210 may have a function of hanging a rope hole, one end of the rope is hung on the neck 6005 of the first connecting piece, and the other end of the rope extends out through the first hole 210. A width W3 of the head 6006 of the first connecting piece is greater than a width W2 of the neck 6005 of the first connecting piece, so that the rope can be prevented from falling off from the neck 6005 of the first connecting piece. Because the function of hanging the rope is implemented by using the neck 6005 of the first connecting piece, product competitiveness is improved.

In a possible implementation, the neck 6005 of the first connecting piece may hang a rope, the first hole 210 may have a function of hanging a rope hole, one end of the rope is hung on the neck 6005 of the first connecting piece, and the other end of the rope extends out through the first hole 210. The length L7 of the head 6006 of the first connecting piece is greater than the length L6 of the neck 6005 of the first connecting piece, and the width W3 of the head 6006 of the first connecting piece is greater than the width W2 of the neck 6005 of the first connecting piece, so that the rope can be prevented from falling off from the neck 6005 of the first connecting piece. Because the function of hanging the rope is implemented by using the neck 6005 of the first connecting piece, product competitiveness is improved.

In this embodiment of this application, the sliding member 600 may have more than one third sliding part 6004, so that the sliding member 600 can stably slide on the bottom surface of the first cavity 220.

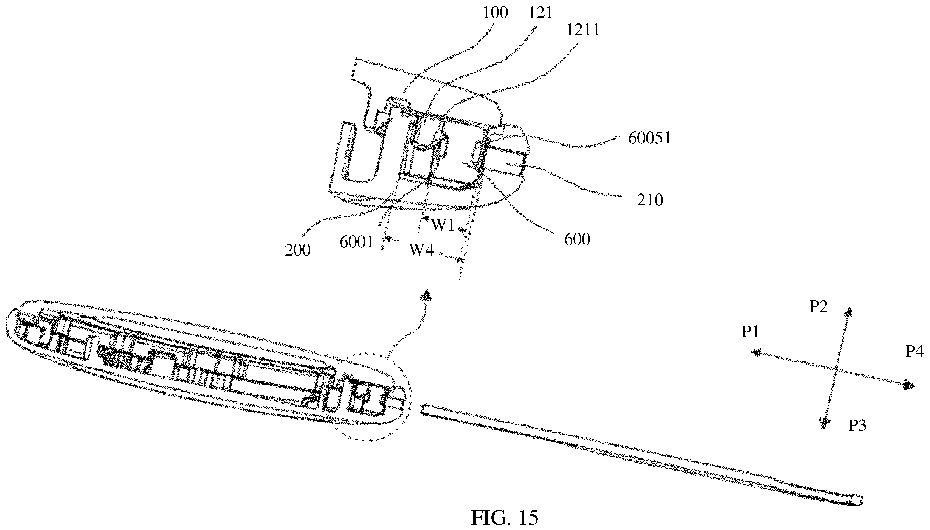

FIG. 14 is a schematic diagram of structures of an electronic device and an ejector pin according to an embodiment of this application. An ejector pin 700 is included. An ejector pin head 710 is disposed on the ejector pin 700, and the ejector pin 700 may move along a first direction P1. The first direction P1 is a direction extending from a first hole 210 to a sliding member 600. FIG. 15 is a sectional view of the electronic device and the ejector pin shown in FIG. 14 along D-D. A first cavity 220 has a width W4, a first surface 1211 of a stopper 121 may be at least partially opposite to a second surface 6001 of the sliding member 600, and a concave part 60051 of a neck 6005 of a first connecting piece is at least partially opposite to the first hole 210.

In this embodiment of this application, more than one first surface 1211 may be disposed on the stopper 121, more than one second surface 6001 may be disposed on the sliding member 600, and a plurality of first surfaces 1211 and a plurality of second surfaces 6001 may be opposite to each other. In another possible design, the first surface 1211 is disposed on the stopper 121, more than one stopper 121 may be disposed in second accommodating space 120, more than one second surface 6001 may be disposed on the sliding member 600, and the plurality of first surfaces 1211 and the plurality of second surfaces 6001 may be opposite to each other.

According to the invention, at least one of the first surface 1211 or the second surface 6001 is a bevel or an arc surface, and a width W1 of the sliding member 600 may be less than a width W4 of the first cavity 220. When an acting force acts on the sliding member 600 through the first hole 210, the sliding member 600 may slide in third sliding space 228 of the first cavity 220 towards a second cavity 230 along a first direction P1, and the stopper 121 generates displacement relative to the sliding member 600 in a second direction P2, where the second direction P2 is a direction in which a second housing 200 extends to a first housing 100. The stopper 121 generates displacement in the second direction P2, so that a first clamping member 111 and a second clamping member 231 change from clamping to separation, and the first housing 100 and the second housing 200 change from clamping to separation, so that an electronic device 10 is opened. Because the sliding member 600 slides in the third sliding space 228 of the first cavity 220 towards the second cavity 230 along the first direction P1, a function of opening the electronic device 10 is implemented, and product competitiveness is improved.

In this embodiment of this application, when the first housing 100 and the second housing 200 are clamped, the stopper 121 may at least partially abut against the sliding member 600, and the first surface 1211 at least partially abut against the second surface 6001 e. When an acting force acts on the sliding member 600 through the first hole 210, the sliding member 600 may slide in the third sliding space 228 of the first cavity 220 towards the second cavity 230 along the first direction P1, and push the stopper 121 to generate displacement relative to the sliding member 600 in the second direction P2, so that the first clamping member 111 and the second clamping member 231 change from clamping to separation, and the first housing 100 and the second housing 200 change from clamping to separation, so that the electronic device 10 is opened. Because the stopper 121 at least partially abuts against the sliding member 600, when the sliding member 600 slides in the third sliding space 228 along the first direction P1 to open the electronic device 10, sliding displacement of the sliding member 600 is shortened, a speed of opening the electronic device 10 is improved, and product competitiveness is improved.

In this embodiment of this application, a sliding slot may be disposed on a bottom surface of the first cavity 220, and a third sliding part 6004 is disposed with the sliding slot. The third sliding part 6004 may slide in the sliding slot. When an acting force acts on the sliding member 600 through the first hole 210, the third sliding part 6004 may slide in the sliding slot towards the second cavity 230 along the first direction P1, and the stopper 121 generates displacement relative to the sliding member 600 in the second direction P2, the first clamping member 111 and the second clamping member 231 change from clamping to separation, and the first housing 100 and the second housing 200 change from clamping to separation, so that the electronic device 10 is opened. Because the third sliding part 6004 slides in the sliding slot towards the second cavity 230 along the first direction P1, a function of opening the electronic device 10 is implemented, and product competitiveness is improved.

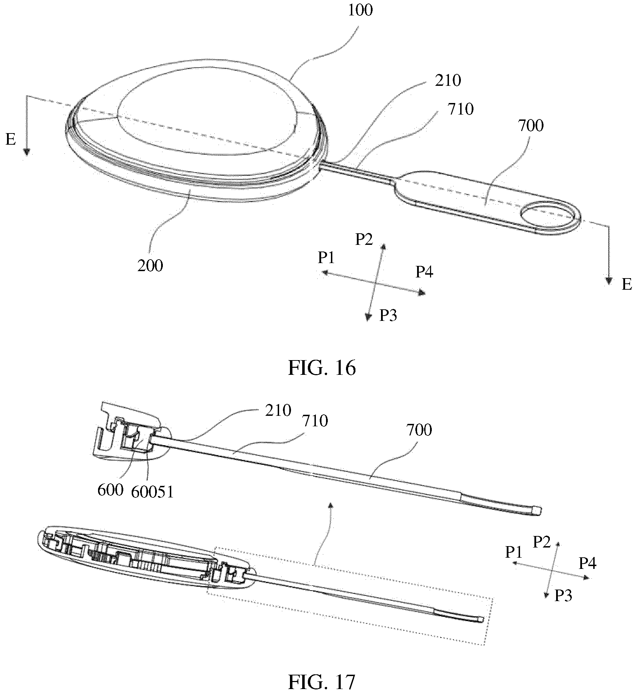

FIG. 16 is a schematic diagram of a structure of the ejector pin shown in FIG. 14 in combination with an electronic device along a first direction. An ejector pin 700 may move along the first direction P1 and be combined with a second housing 200. An ejector pin head 710 of the ejector pin 700 may be at least partially placed in a first hole 210. FIG. 17 is a sectional view of the schematic structural diagram shown in FIG. 16 along E-E. The ejector pin 700 may act on a sliding member 600 through the first hole 210. The sliding member 600 moves along the first direction P1 under the acting force. A stopper 121 generates displacement relative to the sliding member 600 in a second direction P2. A first clamping member 111 and a second clamping member 231 change from clamping to separation, and the first housing 100 and the second housing 200 change from clamping to separation.

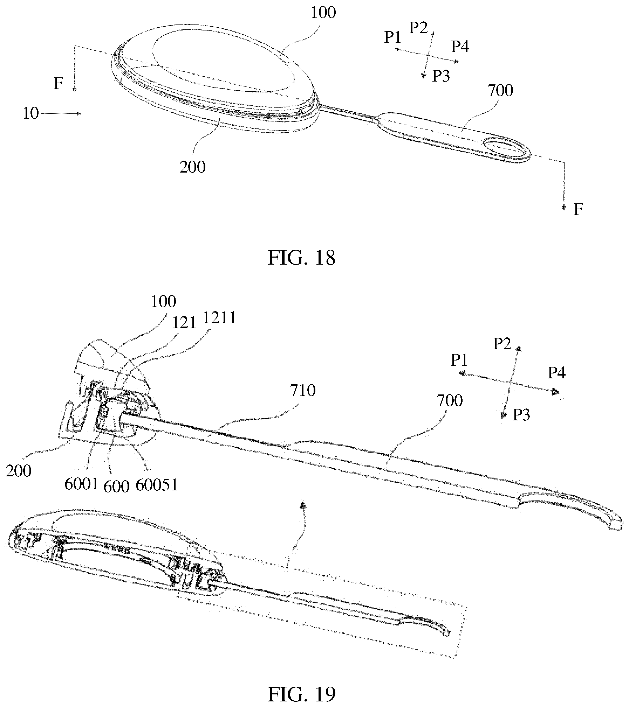

FIG. 18 is a schematic structural diagram in which an electronic device is opened. FIG. 19 is a sectional view of the schematic structural diagram shown in FIG. 18 along F-F. With reference to FIG. 13 and FIG. 19, when an electronic device 10 needs to be opened, an ejector pin 700 moves towards a second housing 200 along a first direction P1, and when an ejector pin head 710 of the ejector pin 700 moves to at least partially abut against a concave part 60051 of a neck 6005 of a first connecting piece, the ejector pin head 710 of the ejector pin 700 pushes the concave part 60051 of the neck 6005 of the first connecting piece to give a first acting force to a first connecting piece 6007 in a first direction P1. The first acting force drives a sliding member 600 to slide on a bottom surface of a first cavity 220 along the first direction P1, and a second surface 6001 of the sliding member 600 also moves in the first direction P1. At least one of a first surface 1211 of a stopper 121 or the second surface 6001 of the sliding member 600 may be a bevel or an arc surface. The first surface 1211 of the stopper 121 is at least partially opposite to the second surface 6001 of the sliding member 600. The second surface 6001 of the sliding member 600 pushes the first surface 1211 of the stopper 121 to give a second acting force to the stopper 121 along the first direction P1, and a component of the second acting force in a second direction P2 is greater than 0. The component of the second acting force in the second direction P2 drives the stopper 121 to move along the second direction P2. The sliding member 600 pushes the first surface 1211 of the stopper 121 to give the second acting force to the stopper 121 to drive a first housing 100 to move along the second direction P2. A first clamping member 111 and a second clamping member 231 change from a clamping state to separation, the first housing 100 and a second housing 200 are separated, and the electronic device 10 is opened. The sliding member 600 is pushed by using the ejector pin 700, so that the sliding member 600 slides in the third sliding space 228 of the first cavity 220 towards the second cavity 230 along the first direction P1, a function of opening the electronic device 10 is implemented, and product competitiveness is improved.

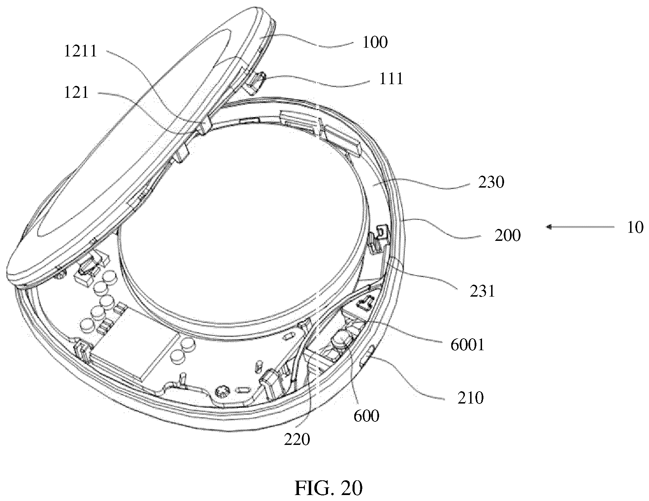

FIG. 20 is a schematic diagram in which an electronic device 10 is in a half-open state. A first clamping member 111 is separated from a second clamping member 231, and a first housing 100 is separated from a second housing 200. Because a first hole 210 inserted into the second housing 200 through an ejector pin 700 of pushes a sliding member 600 inside a first cavity 220 to give a first acting force to the sliding member 600 in a first direction P1, the first acting force drives the sliding member 600 to slide along the first direction P1, a second surface 6001 of the sliding member 600 pushes a first surface 1211 of a stopper 121 to give a second acting force to the stopper 121, and a component of the second acting force in a second direction P2 drives the stopper 121 to move along the second direction P2, the stopper 121 drives the first housing 100 to move along the second direction P2, so that the electronic device 10 is opened. In this embodiment of this application, no buckle needs to be disposed. The sliding member 600 is disposed to cooperate with a housing, and the sliding member 600 is pushed through the ejector pin 700, so that the first clamping member 111 and the second clamping member 231 change from a clamping state to separation, and the first housing 100 and the second housing 200 change from clamping to separation. This ensures integrity of an appearance of the electronic device 10. By using the sliding member 600, the ejector pin 700, and the first hole 210, the housing can change from clamping to separation, and a function of hanging a rope hole can also be implemented. The electronic device 10 does not need an additional hole for hanging a rope, and this reduces a quantity of holes on an appearance of a product, and improves appearance competitiveness of the product.

In this embodiment of this application, when the electronic device 10 needs to be closed, a third acting force is acted on the first housing 100 in a third direction P3 opposite to the second direction P2, and the third acting force drives the first housing 100 to move along the third direction P3 opposite to the second direction P2. When the first surface 1211 of the stopper 121 moves along the third direction P3, the first surface 1211 of the stopper 121 pushes the second surface 6001 of the sliding member 600 to give a fourth acting force to the sliding member 600, a component of the fourth acting force in a fourth direction P4 that is opposite to the first direction P1 is greater than 0, and the component of the fourth acting force in the fourth direction P4 drives the sliding member 600 to move along the fourth direction P4 that is opposite to the first direction P1. When the first clamping member 111 is connected to the second clamping member 231 through buckling, the first housing 100 and the second housing 200 are combined by using the first clamping member 111 and the second clamping member 231, and the electronic device 10 is closed.

According to the electronic device provided in this embodiment of this application, the ejector pin is inserted into a side hole of the second housing, and the first housing is lifted to disassemble the electronic device. Because no buckle needs to be disposed, integrity of an appearance of the electronic device is ensured. The side hole of the second housing may further have a function of hanging a rope hole. Because the electronic device does not need an additional hole for hanging a rope, and this reduces a quantity of holes on an appearance of a product, and improves appearance competitiveness of the product.

It should be further noted that, in this embodiment of this application, relational terms such as first, second, third and fourth are only used to distinguish one entity or operation from another entity or operation, and do not necessarily require or imply that any actual relationship or sequence exists between these entities or operations. Moreover, the terms "include" or any other is intended to cover a non-exclusive inclusion, so that a structure or a device that includes a list of elements not only includes those elements but also includes other elements that are not expressly listed, or further includes elements inherent to such a structure or a device. An element preceded by "includes ..." or "contains ..." does not, without more constraints, preclude the presence of additional identical elements in the structure or device that includes the element.

The protection scope of the invention shall be interpreted according to Article 69 of the EPC protocol.

## Claims

1. An electronic device, comprising a first housing (100) and a second housing (200), wherein
he first housing (100) is provided with a stopper (121) and a first clamping member (111);
the second housing (200) is provided with a first cavity (220), a sliding member (600), and a second clamping member (231);
the first cavity (220) is provided with a first hole (210), the first cavity (220) communicates with the outside through the first hole (210), the sliding member (600) is disposed in the first cavity (220), and the first hole (210) is at least partially opposite to the sliding member (600);
the first housing (100) and the second housing (200) are clamped and connected by using the first clamping member (111) and the second clamping member (231), and when the first clamping member (111) and the second clamping member (231) are clamped, the first housing (100) and the second housing (200) are clamped, projections of the sliding member (600) and the stopper (121) in a first direction (P1) at least partially overlap, and the first direction (P1) is a direction of the first hole (210) towards the sliding member (600); and
when an acting force acts on the sliding member (600) through the first hole (210), the sliding member (600) is adapted to move along the first direction (P1), the stopper (121) is adapted to generate displacement relative to the sliding member (600) in a second direction (P2), the first clamping member (111) and the second clamping member (231) change from clamping to separation, the first housing (100) and the second housing (200) change from clamping to separation, and the second direction (P2) is a direction of the second housing (200) towards the first housing (100); wherein
the stopper (121) comprises a first surface (1211), and the sliding member (600) comprises a second surface (6001); and
at least one of the first surface (1211) or the second surface (6001) is a bevel or an arc surface.

2. The electric device according to claim 1, wherein
that projections of the sliding member (600) and the stopper (121) in a first direction (P1) at least partially overlap comprises that projections of the first surface (1211) and the second surface (6001) in the first direction (P1) at least partially overlap.

3. The electronic device according to claim 1, wherein
when the first housing (100) and the second housing (200) are clamped and connected by using the first clamping member (111) and the second clamping member (231), the stopper (121) at least partially abuts against the sliding member (600).

4. The electronic device according to claim 1, wherein
a second protrusion (224) is disposed on a bottom surface of the first cavity (220), and a side arm (225) is disposed on a side wall of the first cavity (220);
first sliding space (226) is formed between the second protrusion (224) and the side arm (225);
the sliding member (600) is provided with a first sliding part (6002)

5. The electronic device according to any one of claims 1 to 4, wherein
the electronic device further comprises an elastic member (500);
a first protrusion (223) is disposed on the bottom surface of the first cavity (220);
the elastic member (500) is provided with a second hole (501), and the elastic member (500) is disposed in the first cavity (220); and
the elastic member (500) and the first protrusion (223) fit with each other through the second hole (501).

6. The electronic device according to claim 5, wherein
a first step part (503) is disposed on the elastic member (500), and second sliding space (227) is formed between the first step part (503) and the bottom surface of the first cavity (220);
the sliding member (600) is provided with a second sliding part (6003) and a third sliding part (6004); and
the second sliding part (6003) is disposed in the second sliding space (227), and the third sliding part (6004) is in contact with the bottom surface of the first cavity (220).

7. The electronic device according to claim 6, wherein
a sliding slot is disposed on the bottom surface of the first cavity (220), and the sliding slot extends along the first direction (P1);
the third sliding part (6004) is disposed in the sliding slot

8. The electronic device according to claim 5, wherein the elastic member (500) and the first protrusion (223) are in interference fit; or
the elastic member (500) and the first cavity (220) are in interference fit.

9. The electronic device according to any one of claims 1 to 8, wherein
the sliding member (600) is provided with a first connecting piece (6007), and the first connecting piece (6007) is provided with a neck (6005) of the first connecting piece and a head (6006) of the first connecting piece; and
that the first hole (210) is at least partially opposite to the sliding member (600) comprises: the first hole (210) is at least partially opposite to the neck (6005) of the first connecting piece.

10. The electronic device according to claim 9, wherein
a length (L7) of the head (6006) of the first connecting piece is greater than a length (L6) of the neck (6005) of the first connecting piece, or a width (W3) of the head (6006) of the first connecting piece is greater than a width (W2) of the neck (6005) of the first connecting piece.

11. The electronic device according to any one of claims 1 to 10, wherein the stopper (121) and the first housing (100) are integrally formed.

12. The electronic device according to claim 5, wherein a material of the elastic member (500) is at least one of plastic, metal, or rubber.

13. The electronic device according to any one of claims 1 to 12, wherein
the first housing (100) is provided with a sealing kit (112), and the second housing (200) is provided with a second cavity (230); and
when the first housing (100) and the second housing (200) are clamped and connected by using the first clamping member (111) and the second clamping member (231), the second cavity (230) is sealed by using the sealing kit (112).

14. The electronic device according to claim 13, wherein the second cavity (230) is provided with a battery (300) and a circuit board (400).

## Patentansprüche

1. Elektronisches Gerät, das ein erstes Gehäuse (100) und ein zweites Gehäuse (200) umfasst, wobei
das erste Gehäuse (100) mit einem Anschlag (121) und einem ersten Klemmelement (111) versehen ist;
das zweite Gehäuse (200) mit einem ersten Hohlraum (220), einem Gleitelement (600) und einem zweiten Klemmelement (231) versehen ist;
der erste Hohlraum (220) mit einem ersten Loch (210) versehen ist, wobei der erste Hohlraum (220) durch das erste Loch (210) mit der Außenseite in Verbindung steht, das Gleitelement (600) in dem ersten Hohlraum (220) angeordnet ist und das erste Loch (210) dem Gleitelement (600) zumindest teilweise gegenüberliegt;
das erste Gehäuse (100) und das zweite Gehäuse (200) unter Verwendung des ersten Klemmelements (111) und des zweiten Klemmelements (231) verklemmt und verbunden sind, und wobei, wenn das erste Klemmelement (111) und das zweite Klemmelement (231) verklemmt sind, das erste Gehäuse (100) und das zweite Gehäuse (200) verklemmt sind, sich Projektionen des Gleitelements (600) und des Anschlags (121) in einer ersten Richtung (P1) zumindest teilweise überlappen und die erste Richtung (P1) eine Richtung des ersten Lochs (210) zu dem Gleitelement (600) hin ist; und
wenn eine Wirkkraft durch das erste Loch (210) auf das Gleitelement (600) wirkt, das Gleitelement (600) dazu ausgelegt ist, sich entlang der ersten Richtung (P1) zu bewegen, der Anschlag (121) dazu ausgelegt ist, eine Verschiebung relativ zu dem Gleitelement (600) in einer zweiten Richtung (P2) zu erzeugen, das erste Klemmelement (111) und das zweite Klemmelement (231) von einer Verklemmung zu einer Trennung wechseln, das erste Gehäuse (100) und das zweite Gehäuse (200) von einer Verklemmung zu einer Trennung wechseln und die zweite Richtung (P2) eine Richtung des zweiten Gehäuses (200) zu dem ersten Gehäuse (100) hin ist; wobei der Anschlag (121) eine erste Fläche (1211) umfasst und das Gleitelement (600) eine zweite Fläche (6001) umfasst; und
mindestens eine der ersten Fläche (1211) oder der zweiten Fläche (6001) eine abgeschrägte oder eine Bogenfläche ist.

2. Elektronisches Gerät nach Anspruch 1, wobei
dass sich Projektionen des Gleitelements (600) und des Anschlags (121) in einer ersten Richtung (P1) zumindest teilweise überlagern, umfasst, dass sich Projektionen der ersten Fläche (1211) und der zweiten Fläche (6001) in der ersten Richtung (P1) zumindest teilweise überlagern.

3. Elektronisches Gerät nach Anspruch 1, wobei
wenn das erste Gehäuse (100) und das zweite Gehäuse (200) unter Verwendung des ersten Klemmelements (111) und des zweiten Klemmelements (231) verklemmt und verbunden sind, der Anschlag (121) zumindest teilweise an dem Gleitelement (600) anliegt.

4. Elektronisches Gerät nach Anspruch 1, wobei
ein zweiter Vorsprung (224) auf einer unteren Fläche des ersten Hohlraums (220) angeordnet ist und ein Seitenarm (225) auf einer Seitenwand des ersten Hohlraums (220) angeordnet ist;
ein erster Gleitraum (226) zwischen dem zweiten Vorsprung (224) und dem Seitenarm (225) gebildet ist;
das Gleitelement (600) mit einem ersten Gleitteil (6002) versehen ist.

5. Elektronisches Gerät nach einem der Ansprüche 1 bis 4, wobei das elektronische Gerät ferner ein elastisches Element (500) umfasst;
ein erster Vorsprung (223) auf der unteren Fläche des ersten Hohlraums (220) angeordnet ist;
das elastische Element (500) mit einem zweiten Loch (501) versehen ist und das elastische Element (500) in dem ersten Hohlraum (220) angeordnet ist; und
das elastische Element (500) und der erste Vorsprung (223) miteinander durch das zweite Loch (501) passen.

6. Elektronisches Gerät nach Anspruch 5, wobei
ein erster Stufenteil (503) auf dem elastischen Element (500) angeordnet ist und der zweite Gleitraum (227) zwischen dem ersten Stufenteil (503) und der unteren Fläche des ersten Hohlraums (220) gebildet ist;
das Gleitelement (600) mit einem zweiten Gleitteil (6003) und einem dritten Gleitteil (6004) versehen ist; und
der zweite Gleitteil (6003) in dem zweiten Gleitraum (227) angeordnet ist und der dritte Gleitteil (6004) mit der unteren Fläche des ersten Hohlraums (220) in Kontakt steht.

7. Elektronisches Gerät nach Anspruch 6, wobei
ein Gleitschlitz auf der unteren Fläche des ersten Hohlraums (220) angeordnet ist und sich der Gleitschlitz entlang der ersten Richtung (P1) erstreckt;
der dritte Gleitteil (6004) in dem Gleitschlitz angeordnet ist.

8. Elektronisches Gerät nach Anspruch 5, wobei das elastische Element (500) und der erste Vorsprung (223) in Presspassung stehen; oder
wobei das elastische Element (500) und der erste Hohlraum (220) in Presspassung stehen.

9. Elektronisches Gerät nach einem der Ansprüche 1 bis 8, wobei
das Gleitelement (600) mit einem ersten Verbindungsstück (6007) versehen ist und das erste Verbindungsstück (6007) mit einem Hals (6005) des ersten Verbindungsstücks und einem Kopf (6006) des ersten Verbindungsstücks versehen ist; und
dass das erste Loch (210) dem Gleitelement (600) zumindest teilweise gegenüberliegt, Folgendes umfasst: das erste Loch (210) liegt dem Hals (6005) des ersten Verbindungsstücks zumindest teilweise gegenüber.

10. Elektronisches Gerät nach Anspruch 9, wobei
eine Länge (L7) des Kopfes (6006) des ersten Verbindungsstücks größer als eine Länge (L6) des Halses (6005) des ersten Verbindungsstücks ist oder eine Breite (W3) des Kopfes (6006) des ersten Verbindungsstücks größer als eine Breite (W2) des Halses (6005) des ersten Verbindungsstücks ist.

11. Elektronisches Gerät nach einem der Ansprüche 1 bis 10, wobei der Anschlag (121) und das erste Gehäuse (100) integral gebildet sind.

12. Elektronisches Gerät nach Anspruch 5, wobei ein Material des elastischen Elements (500) mindestens eines von Kunststoff, Metall oder Kautschuk ist.

13. Elektronisches Gerät nach einem der Ansprüche 1 bis 12, wobei
das erste Gehäuse (100) mit einem Dichtungssatz (112) versehen ist und das zweite Gehäuse (200) mit einem zweiten Hohlraum (230) versehen ist; und
wenn das erste Gehäuse (100) und das zweite Gehäuse (200) unter Verwendung des ersten Klemmelements (111) und des zweiten Klemmelements (231) verklemmt und verbunden sind, der zweite Hohlraum (230) unter Verwendung des Dichtungssatzes (112) abgedichtet ist.

14. Elektronisches Gerät nach Anspruch 13, wobei der zweite Hohlraum (230) mit einer Batterie (300) und einer Leiterplatte (400) versehen ist.

## Revendications

1. Dispositif électronique, comprenant un premier boîtier (100) et un second boîtier (200), dans lequel le premier boîtier (100) est muni d'une butée (121) et d'un premier organe de serrage (111) ;
le second boîtier (200) est muni d'une première cavité (220), d'un élément coulissant (600) et d'un second organe de serrage (231) ;
la première cavité (220) est munie d'un premier trou (210), la première cavité (220) communique avec l'extérieur à travers le premier trou (210), l'élément coulissant (600) est disposé dans la première cavité (220) et le premier trou (210) est au moins en partie opposé à l'élément coulissant (600) ;
le premier boîtier (100) et le second boîtier (200) sont serrés et reliés au moyen du premier organe de serrage (111) et du second organe de serrage (231), et lorsque le premier organe de serrage (111) et le second organe de serrage (231) sont serrés, le premier boîtier (100) et le second boîtier (200) sont serrés, des projections de l'élément coulissant (600) et de la butée (121) dans une première direction (P1) se chevauchent au moins en partie, et la première direction (P1) est une direction du premier trou (210) vers l'élément coulissant (600) ; et
lorsqu'une force d'action agit sur l'élément coulissant (600) à travers le premier trou (210), l'élément coulissant (600) est conçu pour se déplacer dans la première direction (P1), la butée (121) est conçue pour générer un déplacement par rapport à l'élément coulissant (600) dans une seconde direction (P2), le premier organe de serrage (111) et le second organe de serrage (231) passent du serrage à la séparation, le premier boîtier (100) et le second boîtier (200) passent du serrage à la séparation, et la seconde direction (P2) est une direction du second boîtier (200) vers le premier boîtier (100) ; dans lequel
la butée (121) comprend une première surface (1211), et l'élément coulissant (600) comprend une seconde surface (6001) ; et
au moins l'une de la première surface (1211) ou de la seconde surface (6001) est une surface en biseau ou en arc.

2. Dispositif électronique selon la revendication 1, dans lequel
le fait que les projections de l'élément coulissant (600) et de la butée (121) dans une première direction (P1) se chevauchent au moins en partie comprend le fait que des projections de la première surface (1211) et de la seconde surface (6001) dans la première direction (P1) se chevauchent au moins en partie.

3. Dispositif électronique selon la revendication 1, dans lequel
lorsque le premier boîtier (100) et le second boîtier (200) sont serrés et reliés au moyen du premier organe de serrage (111) et du second organe de serrage (231), la butée (121) vient au moins en partie en butée contre l'élément coulissant (600).

4. Dispositif électronique selon la revendication 1, dans lequel
une seconde saillie (224) est disposée sur une surface inférieure de la première cavité (220), et un bras latéral (225) est disposé sur une paroi latérale de la première cavité (220) ;
un premier espace coulissant (226) est formé entre la seconde saillie (224) et le bras latéral (225) ;
l'élément coulissant (600) est muni d'une première partie coulissante (6002).

5. Dispositif électronique selon l'une quelconque des revendications 1 à 4, dans lequel
le dispositif électronique comprend en outre un organe élastique (500) ;
une première saillie (223) est disposée sur la surface inférieure de la première cavité (220) ;
l'organe élastique (500) est muni d'un second trou (501), et l'organe élastique (500) est disposé dans la première cavité (220) ; et
l'organe élastique (500) et la première saillie (223) s'ajustent l'un à l'autre à travers le second trou (501).

6. Dispositif électronique selon la revendication 5, dans lequel
une première partie étagée (503) est disposée sur l'organe élastique (500), et un second espace coulissant (227) est formé entre la première partie étagée (503) et la surface inférieure de la première cavité (220) ;
l'élément coulissant (600) est muni d'une deuxième partie coulissante (6003) et d'une troisième partie coulissante (6004) ; et
la deuxième partie coulissante (6003) est disposée dans le second espace coulissant (227), et la troisième partie coulissante (6004) est en contact avec la surface inférieure de la première cavité (220).

7. Dispositif électronique selon la revendication 6, dans lequel
une fente coulissante est disposée sur la surface inférieure de la première cavité (220), et la fente coulissante s'étend dans la première direction (P1) ;
la troisième partie coulissante (6004) est disposée dans la fente coulissante.

8. Dispositif électronique selon la revendication 5, dans lequel l'organe élastique (500) et la première saillie (223) sont ajustés par serrage ; et
l'organe élastique (500) et la première cavité (220) sont ajustés par serrage.

9. Dispositif électronique selon l'une quelconque des revendications 1 à 8, dans lequel l'élément coulissant (600) est muni d'une première pièce de liaison (6007), et la première pièce de liaison (6007) est munie d'un col (6005) de la première pièce de liaison et d'une tête (6006) de la première pièce de liaison ; et
le fait que le premier trou (210) est au moins en partie opposé à l'élément coulissant (600) comprend : le fait que le premier trou (210) est au moins en partie opposé au col (6005) de la première pièce de liaison.

10. Dispositif électronique selon la revendication 9, dans lequel
une longueur (L7) de la tête (6006) de la première pièce de liaison est supérieure à une longueur (L6) du col (6005) de la première pièce de liaison, ou une largeur (W3) de la tête (6006) de la première pièce de liaison est supérieure à une largeur (W2) du col (6005) de la première pièce de liaison.

11. Dispositif électronique selon l'une quelconque des revendications 1 à 10, dans lequel la butée (121) et le premier boîtier (100) sont formés d'un seul tenant.

12. Dispositif électronique selon la revendication 5, dans lequel un matériau de l'organe élastique (500) est au moins l'un d'un plastique, d'un métal ou d'un caoutchouc.

13. Dispositif électronique selon l'une quelconque des revendications 1 à 12, dans lequel le premier boîtier (100) est muni d'un kit d'étanchéité (112), et le second boîtier (200) est muni d'une seconde cavité (230) ; et
lorsque le premier boîtier (100) et le second boîtier (200) sont serrés et reliés au moyen du premier organe de serrage (111) et du second organe de serrage (231), la seconde cavité (230) est scellée au moyen du kit d'étanchéité (112).

14. Dispositif électronique selon la revendication 13, dans lequel la seconde cavité (230) est munie d'une batterie (300) et d'une carte de circuit imprimé (400).
